# EUROPEAN PATENT APPLICATION

(11) **EP 4 549 373 A1**
(43) Date of publication of application: **07.05.2025**
(21) Application number: 24209293.0
(22) Date of filing: 28.10.2024
(51) Int. Cl.: B81B 7/00, H01L 23/498

(54) **MEMS SWITCH WITH PLANAR THROUGH GLASS VIAS (TGV)**

(30) Priority: 31.10.2023 US 202318498766
(71) Applicant: Menlo Microsystems, Inc., Irvine, CA 92618 (US)
(72) Inventor: SHOREY, Aric, New York, 14534 (US); STROHMAYER, Matthew, New York, 12302 (US)
(74) Representative: Marks & Clerk LLP

(57) **Abstract**

A micro-electromechanical (MEMS) component may comprise a glass substrate, a MEMS device disposed on the glass substrate, and a glass cap disposed on the glass substrate. The glass cap may have at least one electrically conductive via therethrough, comprising a cylindrical void traversing the glass cap from a top surface of the glass cap to a bottom surface of the glass cap, and a metal conformal coating disposed on an interior sidewall of the cylindrical void. The metal conformal coating may have a top end and a bottom end. A flexible composite material may be disposed in the cylindrical void from the top surface of the glass cap to the bottom surface of the glass cap. A top planar cap may be coupled to the top end of the metal conformal coating, and a bottom planar cap may be coupled to the bottom end of the metal conformal coating.

## Description

### BACKGROUND

A microelectromechanical system (MEMS) component may comprise a MEMS device on a glass substrate and a glass cap (or cover), arranged to encapsulate the MEMS device within a hermetically-sealed cavity. An electrical signal that originates outside the MEMS component may need to be communicated to/from the MEMS device without impacting the hermeticity of the sealed cavity.

### SUMMARY

The described embodiments of the invention are directed to a microelectromechanical system (MEMS) component comprising a MEMS device on a glass substrate, and a glass cap (or lid or cover) bonded to the substrate to form a hermetically sealed cavity that houses the MEMS device. The MEMS component further comprises at least one planar through-glass via (TGV) that facilitates communication of an electrical signal from the MEMS device within the cavity to a device or system outside of the cavity (or vice versa). The TGV is configured and arranged to prevent gas flowing into or out of the cavity by way of the TGV. In the example embodiments described herein, the TGV is implemented in the glass cap, although in other embodiments the TGV may be implemented in the device substrate. As is described in more detail herein, a "planar" TGV refers to the ends of the TGV being planar so that, for example, the ends of the TGV may be coplanar with the outer surface of the cap.

In one aspect, the invention may be a micro-electromechanical (MEMS) component, comprising a glass substrate, a MEMS device disposed on the glass substrate, and a glass cap (i) having at least one conductive via therethrough and (ii) attached to the glass substrate thereby encapsulating and hermetically sealing the MEMS device within a cavity. The at least one conductive via may have a top planar end cap coupled to a top end of the electrically-conductive via and a bottom planar end cap coupled to a bottom end of the electrically-conductive via.

In an embodiment, the at least one conductive via may be cylindrical. The at least one conductive via may comprise a metal conformal coating on an interior wall of a void through the glass cap, such that the conformal coating surrounds a remaining void. The remaining void may be filled, from the top end to the bottom end, with a flexible composite material. The flexible composite material may be conductive or substantially non-conductive.

The flexible composite material may comprise a mixture of materials that forms a hermetic seal from the top end to the bottom end. A top surface of the top planar cap may be substantially coplanar with a top surface of the glass cap, and a bottom surface of the bottom planar cap may be substantially coplanar with a bottom surface of the glass cap. The bottom planar cap may be electrically coupled to the MEMS device. The glass cap may be bonded to the glass substrate such that the MEMS device is hermetically sealed within a cavity formed between the glass substrate and the glass cap.

In another aspect, the invention may be a micro-electromechanical (MEMS) component, comprising a glass substrate, a MEMS device disposed on the glass substrate, and a glass cap disposed on the glass substrate. The glass cap may have at least one electrically conductive via therethrough. The conductive via may comprise a cylindrical void traversing the glass cap from a top surface of the glass cap to a bottom surface of the glass cap, and a metal conformal coating disposed on an interior sidewall of the cylindrical void. The metal conformal coating may have a top end at the top surface of the glass cap and a bottom end at the bottom surface of the glass cap. The conductive via may further comprise a flexible composite material disposed in the cylindrical void from the top surface of the glass cap to the bottom surface of the glass cap, a top planar cap coupled to the top end of the metal conformal coating, and a bottom planar cap coupled to the bottom end of the metal conformal coating.

The glass cap may be bonded to the glass substrate such that the MEMS device is hermetically sealed within a cavity formed between the glass substrate and the glass cap. The flexible composite material may be conductive or non-conductive. The flexible composite material may comprise a mixture of materials that forms a hermetic seal from the top end to the bottom end. A top surface of the top planar cap may be substantially coplanar with a top surface of the glass cap, and a bottom surface of the bottom planar cap may be substantially coplanar with a bottom surface of the glass cap.

In another aspect, the invention may be a method of conveying an electrical signal to an encapsulated micro-electromechanical (MEMS) device, comprising providing a MEMS device disposed on a glass substrate, and forming at least one conductive via through a glass cap. The at least one conductive via may have a top planar cap coupled to a top end of the electrically-conductive via and a bottom planar cap coupled to a bottom end of the electrically-conductive via. The method may further comprise attaching the glass cap to the glass substrate thereby encapsulating and hermetically sealing the MEMS device within a cavity.

The method may further comprise bonding the glass cap to the glass substrate such that the MEMS device is hermetically sealed within a cavity formed between the glass substrate and the glass cap. The method may further comprise electrically coupling the bottom planar cap to the MEMS device. The method may further comprise fabricating a top surface of the top planar cap to be substantially coplanar with a top surface of the glass cap, and a bottom surface of the bottom planar cap to be substantially coplanar with a bottom surface of the glass cap.

### BRIEF DESCRIPTION OF THE DRAWINGS

The foregoing will be apparent from the following more particular description of example embodiments, as illustrated in the accompanying drawings in which like reference characters refer to the same parts throughout the different views. The drawings are not necessarily to scale, emphasis instead being placed upon illustrating embodiments.
FIGs. 1A and 1B show an example MEMS component structure.
FIG. 2 shows a cross-sectional view of a pinched via.
FIGs. 3A shows an example embodiment of a hybrid via according to the invention.
FIG. 3B shows a more detailed view of the hybrid via depicted in FIG. 3A according to the invention.
FIG. 4 shows the hybrid via described with respect to FIGs. 3A and 3B in an example MEMS component architecture.
FIG. 5 shows a hybrid via traversing a glass substrate.

### DETAILED DESCRIPTION

A description of example embodiments follows.

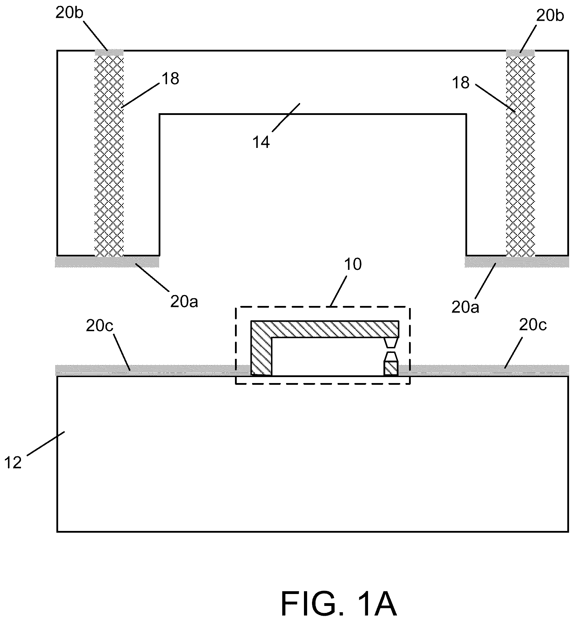

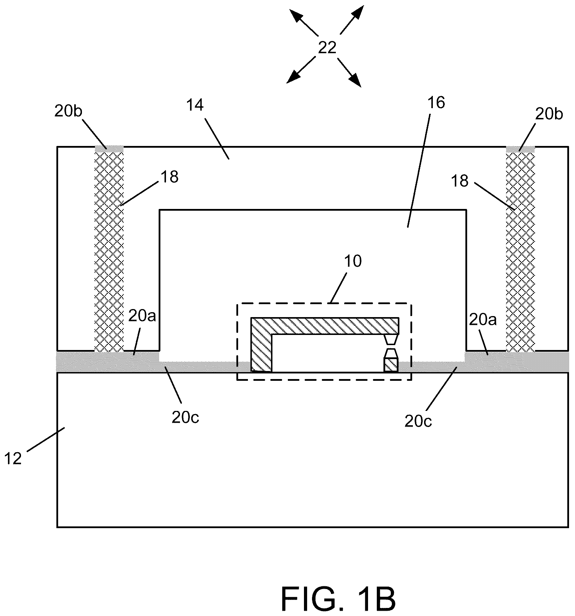

A microelectromechanical system (MEMS) component may consist of a two-part structure, as shown in FIG. 1A. The first part comprises a MEMS device structure 10 constructed on a glass substrate 12, and the second part comprises a glass cap 14 that surrounds and covers the MEMS device structure 10, as shown in FIG. 1B, to form a hermetically sealed cavity 16 in which the MEMS device structure 10 resides.

The glass cap 14 and the glass substrate 12 may be fabricated from any of a variety of glass materials, such as silicon dioxide (SiO₂), fused silica, silica glass, quartz, sodium-doped glass, and borosilicate glass. In other embodiments, the substrate and cap may consist of non-glass materials, such as Silicon (Si), Silicon Carbide (SiC) and Galium Nitride (GaN), although other non-glass materials may also be used.

One or more electrical conductors 18 may pass through the glass cap 14 to the MEMS device structure 10, to provide electrical access to the MEMS device structure 10 from outside the hermetically sealed cavity 16. These electrical conductors 18 may be in the form of through-glass vias (TGVs) 18 that facilitate the transmission of electrical signals through the glass cap 14 while maintaining the hermeticity of the sealed cavity 16. The embodiments described herein may be configured to provide a hermetic seal, between the device environment within the sealed cavity 16 and the external environment 22, capable of providing a measured helium leak rate that is less than 1.0 x 10-6 (atm-cm)3/second.

The electrically conductive material within the TGV 18 may be copper, with a gold layer 20a coupled to the bottom (i.e., substrate-facing) end of the TGV 18, and a gold layer 20b (external bonding pad) coupled to the top end of the TGV 18. Gold layers 20c are disposed on the substrate 12 and electrically coupled to the MEMS device structure 10. The gold layer 20a at the bottom of the TGV 18 couples to the gold layer 20c on the substrate 12 by thermal-compression bonding, thereby forming the hermetically sealed cavity 16, as shown in FIG. 1B.

Certain aspects of the MEMS component shown in FIGs. 1A and 1B may complicate implementation of the TGV 18. Those aspects may include, for example, (i) a requirement that the MEMS device cavity be hermetically sealed, (ii) a need to mitigate stress applied to the glass that surrounds the TGV when the glass and TGV materials have different coefficients of thermal expansion (CTE), and (iii) the need to prevent contaminants from being introduced into the MEMS device cavity.

Conformal plating of the void of the TGV opening may provide an electrically-conductive path through the glass cap or glass substrate, and does not exert stress on the surrounding glass because conformal plating is much less susceptible to CTE induced stresses created by a completely filled metallic via. That is, a conformally filled via is only constrained along the outer wall, and therefore free to expand in more directions at increased temperature and therefore creates lower stresses.. Conformal plating, however, only lines the interior walls of the TGV void, so it cannot support a TGV that maintains a hermetic seal.

A TGV that is completely filled with a metal or other conductive material provides an electrically-conductive path, can support a TGV that maintains a hermetic seal, and can support flat, planar endcaps. The CTEs of the fill metal and the surrounding glass may be different enough such that, over temperature, the stresses generated due to the CTE differences may crack or otherwise damage the glass.

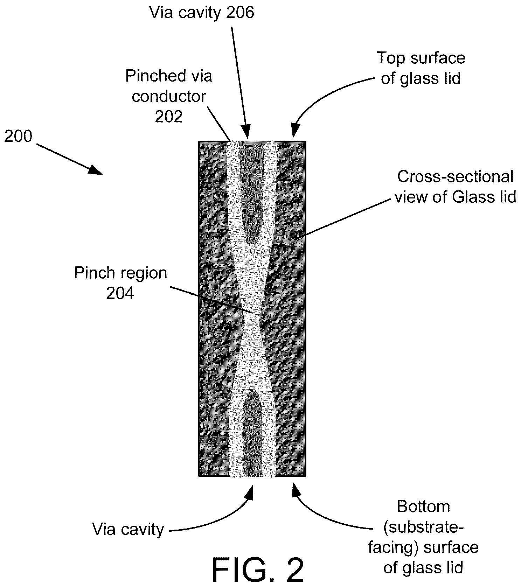

A pinched TGV 200, as shown in FIG. 2, provides an electrically-conductive path, and the shape of the pinched via 200 is designed to provide relief for CTE-induced stress on the surrounding glass. Further, the pinched via conductor 202 is completely filled at the pinched region 204, which facilitates a hermetic seal of the MEMS device cavity.

The via cavity 206, however, may provide a reservoir for contaminants to collect. It can be difficult to completely remove such contaminants, even if the via cavity is relatively shallow. During high-temperature processing (e.g., thermal bonding of the glass cap to the glass substrate), the contaminants may release into the sealed MEMS device chamber and cause degraded and/or unstable performance of the MEMS device.

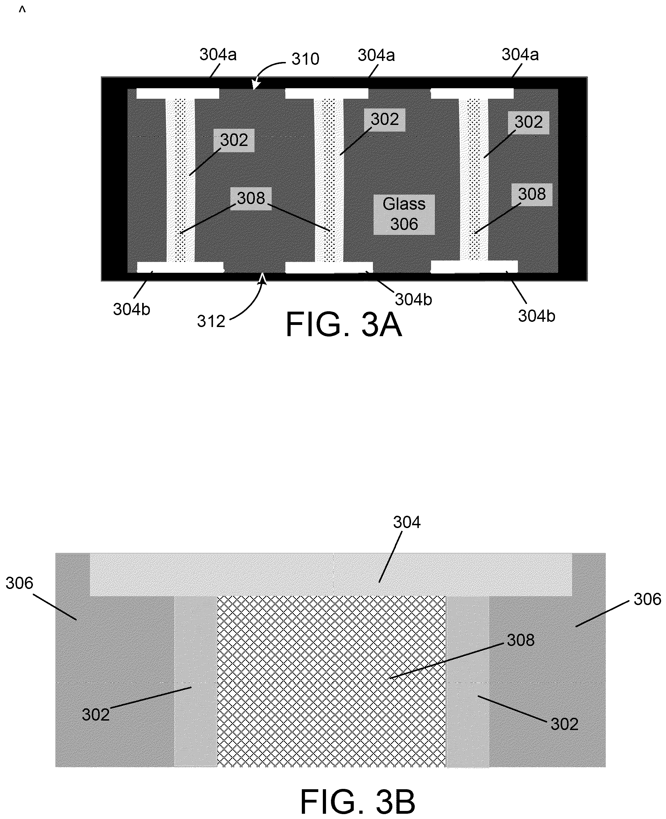

The described embodiments are directed to a hybrid TGV architecture, which combines the advantages of several types of TGV architectures. The hybrid TGV architecture of an example embodiment, shown in FIG. 3A, implements a TGV with conformal plating 302 extending through glass 306 (e.g., a glass device substrate or a glass cap/cover), with the TGV void filled with a composite material 308. The composite material 308 may be electrically conductive or electrically non-conductive because, for the case of an electrically non-conductive composite material 308, the conformal plating 302 provides electrical conductivity of the TGV through the glass. The composite material 308 (i) may be flexible enough to provide relief from CTE differences between the TGV and the surrounding glass (as with pinched via), and (ii) facilitate a hermetic seal of the TGV between the exterior surface of the glass exterior 310 and glass interior 312 by impeding a flow of contaminants through the TGV. Each end of the TGVs depicted in FIGs. 3A and 3B is terminated with a top planar end cap 304a and a bottom planar end cap 304b. The end caps 304a, 304b are configured and arranged such that an outer surface of the top end cap 304a is coplanar with the either the surface of the glass exterior 310, and the bottom end cap 304b is coplanar with the surface of the glass interior 312.

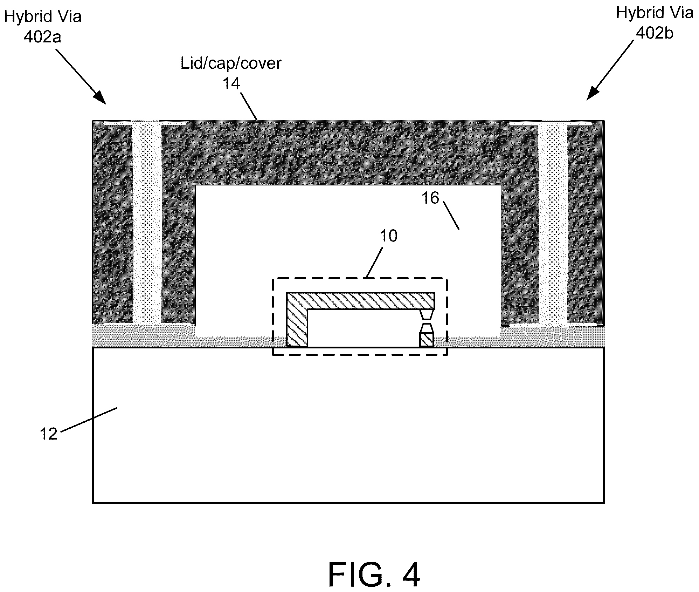

FIG. 4 shows an example embodiment of a MEMS component according to the invention. The hybrid vias 402a, 402b, which were described in detail herein and depicted in FIGs. 3A and 3B, are shown in the example architecture associated with FIGs. 1A and 1B. The cover 14 is attached to the substrate 12 using thermos-compression bonding, forming a hermetically sealed cavity 16 that encapsulates the MEMS device 10.

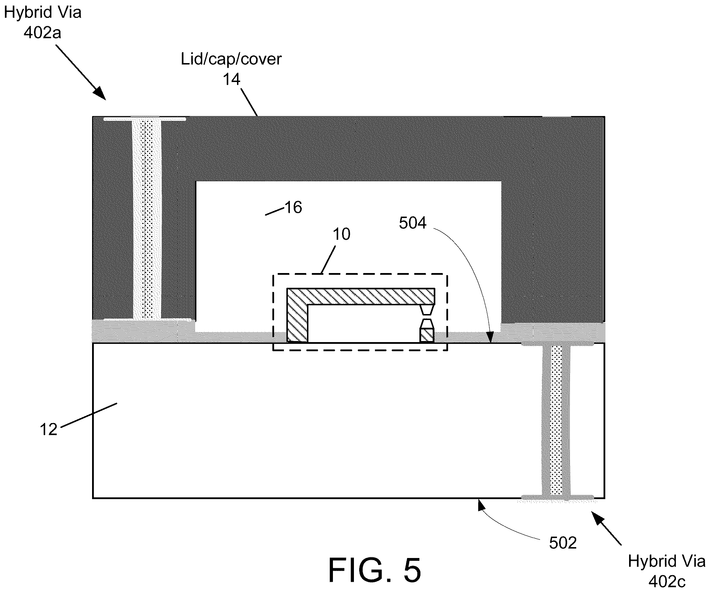

The examples herein have been directed to a hybrid via that traverses a glass cap, the hybrid via as described herein may also be used to convey a signal through the device substrate. FIG. 5 illustrates an example embodiment that includes a hybrid via 401c extending from the bottom surface 502 of the glass substrate 12 to the top surface 504 of the glass substrate.

While example embodiments have been particularly shown and described, it will be understood by those skilled in the art that various changes in form and details may be made therein without departing from the scope of the embodiments encompassed by the appended claims.

Aspects of the present disclosure may be defined by way of the following clauses:
1. A micro-electromechanical (MEMS) component, comprising:
   a glass substrate;
   a MEMS device disposed on the glass substrate;
   a glass cap (i) having at least one conductive via therethrough and (ii) attached to the glass substrate thereby encapsulating and hermetically sealing the MEMS device within a cavity, the at least one conductive via having a top planar end cap coupled to a top end of the electrically-conductive via and a bottom planar end cap coupled to a bottom end of the electrically-conductive via.
2. The MEMS component of clause 1, wherein the at least one conductive via is cylindrical.
3. The MEMS component of clause 2, wherein the at least one conductive via comprises a metal conformal coating on an interior wall of a void through the glass cap, such that the conformal coating surrounds a remaining void.
4. The MEMS component of clause 3, wherein the remaining void is filled, from the top end to the bottom end, with a flexible composite material.
5. The MEMS component of clause 4, wherein the flexible composite material is conductive.
6. The MEMS component of clause 4, wherein the flexible composite material is substantially non-conductive.
7. The MEMS component of clause 4, wherein the flexible composite material comprises a mixture of materials that forms a hermetic seal from the top end to the bottom end.
8. The MEMS component of clause 4, wherein a top surface of the top planar cap is substantially coplanar with a top surface of the glass cap, and a bottom surface of the bottom planar cap is substantially coplanar with a bottom surface of the glass cap.
9. The MEMS component of clause 1, wherein the bottom planar cap is electrically coupled to the MEMS device.
10. The MEMS component of clause 1, wherein the glass cap is bonded to the glass substrate such that the MEMS device is hermetically sealed within a cavity formed between the glass substrate and the glass cap.
11. A micro-electromechanical (MEMS) component, comprising:
   a glass substrate;
   a MEMS device disposed on the glass substrate;
   a glass cap disposed on the glass substrate, the glass cap having at least one electrically conductive via therethrough, the conductive via comprising:
      (i) a cylindrical void traversing the glass cap from a top surface of the glass cap to a bottom surface of the glass cap;
      (ii) a metal conformal coating disposed on an interior sidewall of the cylindrical void, the metal conformal coating having a top end at the top surface of the glass cap and a bottom end at the bottom surface of the glass cap;
      (iii) a flexible composite material disposed in the cylindrical void from the top surface of the glass cap to the bottom surface of the glass cap;
      (iv) a top planar cap coupled to the top end of the metal conformal coating; and
      (v) a bottom planar cap coupled to the bottom end of the metal conformal coating.
12. The MEMS component of clause 11, wherein the glass cap is bonded to the glass substrate such that the MEMS device is hermetically sealed within a cavity formed between the glass substrate and the glass cap.
13. The MEMS component of clause 11, wherein the flexible composite material is conductive.
14. The MEMS component of clause 11, wherein the flexible composite material is substantially non-conductive.
15. The MEMS component of clause 11, wherein the flexible composite material comprises a mixture of materials that forms a hermetic seal from the top end to the bottom end.
16. The MEMS component of clause 11, wherein a top surface of the top planar cap is substantially coplanar with a top surface of the glass cap, and a bottom surface of the bottom planar cap is substantially coplanar with a bottom surface of the glass cap.
17. A method of conveying an electrical signal to an encapsulated micro-electromechanical (MEMS) device, comprising:
   providing a MEMS device disposed on a glass substrate;
   forming at least one conductive via through a glass cap, the at least one conductive via having a top planar cap coupled to a top end of the electrically-conductive via and a bottom planar cap coupled to a bottom end of the electrically-conductive via; and
   attaching the glass cap to the glass substrate thereby encapsulating and hermetically sealing the MEMS device within a cavity.
18. The method of clause 17, further comprising bonding the glass cap to the glass substrate such that the MEMS device is hermetically sealed within a cavity formed between the glass substrate and the glass cap.
19. The method of clause 17, further comprising electrically coupling the bottom planar cap to the MEMS device.
20. The method of clause 17, further comprising fabricating a top surface of the top planar cap to be substantially coplanar with a top surface of the glass cap, and a bottom surface of the bottom planar cap to be substantially coplanar with a bottom surface of the glass cap.

## Claims

1. A micro-electromechanical, MEMS, component, comprising:
a glass substrate;
a MEMS device disposed on the glass substrate;
a glass cap (i) having at least one conductive via therethrough and (ii) attached to the glass substrate thereby encapsulating and hermetically sealing the MEMS device within a cavity, the at least one conductive via having a top planar end cap coupled to a top end of the electrically-conductive via and a bottom planar end cap coupled to a bottom end of the electrically-conductive via.

2. The MEMS component of claim 1, wherein the at least one conductive via is cylindrical.

3. The MEMS component of claim 2, wherein the at least one conductive via comprises a metal conformal coating on an interior wall of a void through the glass cap, such that the conformal coating surrounds a remaining void.

4. The MEMS component of claim 3, wherein the remaining void is filled, from the top end to the bottom end, with a flexible composite material.

5. The MEMS component of claim 1, wherein the bottom planar cap is electrically coupled to the MEMS device.

6. The MEMS component of claim 1, wherein the glass cap is bonded to the glass substrate such that the MEMS device is hermetically sealed within a cavity formed between the glass substrate and the glass cap.

7. A micro-electromechanical, MEMS, component, comprising:
a glass substrate;
a MEMS device disposed on the glass substrate;
a glass cap disposed on the glass substrate, the glass cap having at least one electrically conductive via therethrough, the conductive via comprising:
(i) a cylindrical void traversing the glass cap from a top surface of the glass cap to a bottom surface of the glass cap;
(ii) a metal conformal coating disposed on an interior sidewall of the cylindrical void, the metal conformal coating having a top end at the top surface of the glass cap and a bottom end at the bottom surface of the glass cap;
(iii) a flexible composite material disposed in the cylindrical void from the top surface of the glass cap to the bottom surface of the glass cap;
(iv) a top planar cap coupled to the top end of the metal conformal coating; and
(v) a bottom planar cap coupled to the bottom end of the metal conformal coating.

8. The MEMS component of claim 7, wherein the glass cap is bonded to the glass substrate such that the MEMS device is hermetically sealed within a cavity formed between the glass substrate and the glass cap.

9. The MEMS component of claim 4 or 7, wherein the flexible composite material is conductive or substantially non-conductive.

10. The MEMS component of claim 4 or 7, wherein the flexible composite material comprises a mixture of materials that forms a hermetic seal from the top end to the bottom end.

11. The MEMS component of claim 4 or 7, wherein a top surface of the top planar cap is substantially coplanar with a top surface of the glass cap, and a bottom surface of the bottom planar cap is substantially coplanar with a bottom surface of the glass cap.

12. A method of conveying an electrical signal to an encapsulated micro-electromechanical, MEMS, device, comprising:
providing a MEMS device disposed on a glass substrate;
forming at least one conductive via through a glass cap, the at least one conductive via having a top planar cap coupled to a top end of the electrically-conductive via and a bottom planar cap coupled to a bottom end of the electrically-conductive via; and
attaching the glass cap to the glass substrate thereby encapsulating and hermetically sealing the MEMS device within a cavity.

13. The method of claim 12, further comprising bonding the glass cap to the glass substrate such that the MEMS device is hermetically sealed within a cavity formed between the glass substrate and the glass cap.

14. The method of claim 12, further comprising electrically coupling the bottom planar cap to the MEMS device.

15. The method of claim 12, further comprising fabricating a top surface of the top planar cap to be substantially coplanar with a top surface of the glass cap, and a bottom surface of the bottom planar cap to be substantially coplanar with a bottom surface of the glass cap.
